# FASCICULE DE BREVET EUROPEEN

(11) **EP 3 493 277 B1**
(45) Date de publication et mention de la délivrance du brevet: **20.05.2020**
(21) Numéro de dépôt: 18208859.1
(22) Date de dépôt: 28.11.2018
(51) Int. Cl.: H01L 31/18, H01L 31/05

(54) **PROCÉDÉ D'INTERCONNEXION DE CELLULES PHOTOVOLTAÏQUES AVEC UNE ÉLECTRODE POURVUE DE NANOFILS MÉTALLIQUES**
VERFAHREN ZUR VERBINDUNG VON PHOTOVOLTAIKZELLEN MIT EINER ELEKTRODE, AUSGESTATTET MIT METALLNANODRÄHTEN
METHOD FOR INTERCONNECTING PHOTOVOLTAIC CELLS WITH AN ELECTRODE HAVING METAL NANOWIRES

(30) Priorité: 30.11.2017 FR 1761486
(43) Date de publication de la demande: 05.06.2019
(73) Titulaire: Commissariat à l'énergie atomique et aux énergies alternatives, 75015 Paris (FR)
(72) Inventeur: COMMAULT, Benjamin, 73370 LE BOURGET-DU-LAC (FR); LEFILLASTRE, Paul, 75013 PARIS (FR); SIMONATO, Jean-Pierre, 38360 SASSENAGE (FR); CELLE, Caroline, 42700 FIRMINY (FR)
(74) Mandataire: Brevalex

(56) Documents cités:
- WO-A1-2016/198797
- DE-C1- 10 239 845
- SÖDERSTRÖM T ET AL: "Smart Wire Connection Technology", ENERGY PROCEDIA, 1 janvier 2013 (2013-01-01), pages 495-499, XP055271426, NL ISSN: 1876-6102

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, notamment pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention propose ainsi un procédé d'interconnexion de cellules photovoltaïques utilisant une électrode comprenant des nanofils métalliques, ainsi qu'un procédé de fabrication d'un module photovoltaïque associé.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque peut quant à elle être réalisée à base de verre ou de métal, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques, se présentant sous forme de fines plaques d'environ 200 µm d'épaisseur, peuvent être reliées électriquement entre elles (interconnectées) par des éléments de contact électrique avant et arrière, appelés conducteurs de liaison, et formés par exemple par des bandes (ou rubans) ou fils de cuivre étamé, notamment respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

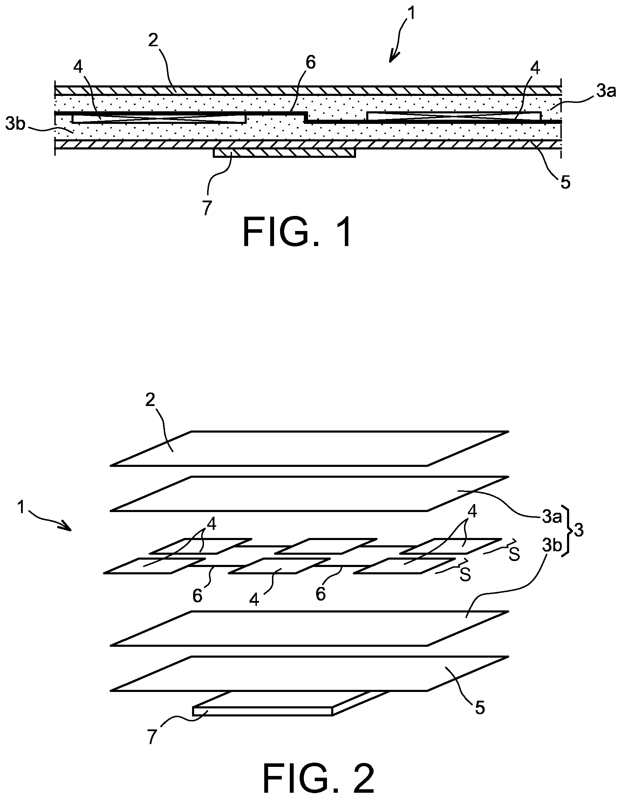

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

Par ailleurs, les figures 1 et 2 représentent également la boîte de jonction 7 du module photovoltaïque 1, destinée à recevoir le câblage nécessaire à l'exploitation du module et raccordant les bandes de cuivre du circuit de cellules photovoltaïques. Classiquement, cette boîte de jonction 7 est réalisée en plastique ou en caoutchouc, et présente une étanchéité complète. Enfin, bien que non représenté sur les figures 1 et 2, un cadre en aluminium est prévu autour de l'ensemble des couches décrites auparavant pour finaliser le module photovoltaïque.

Ainsi, un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées, ou « pseudo-carrées », de 156 mm de côté, réparties en six chaînes ou séries S, comme visible sur la figure 2, appelées encore « strings » selon la dénomination anglaise, de dix cellules interconnectées en série. Les six chaînes de cellules photovoltaïques sont également interconnectées en série.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites, typiquement de dimension inférieure à 100 µm. Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

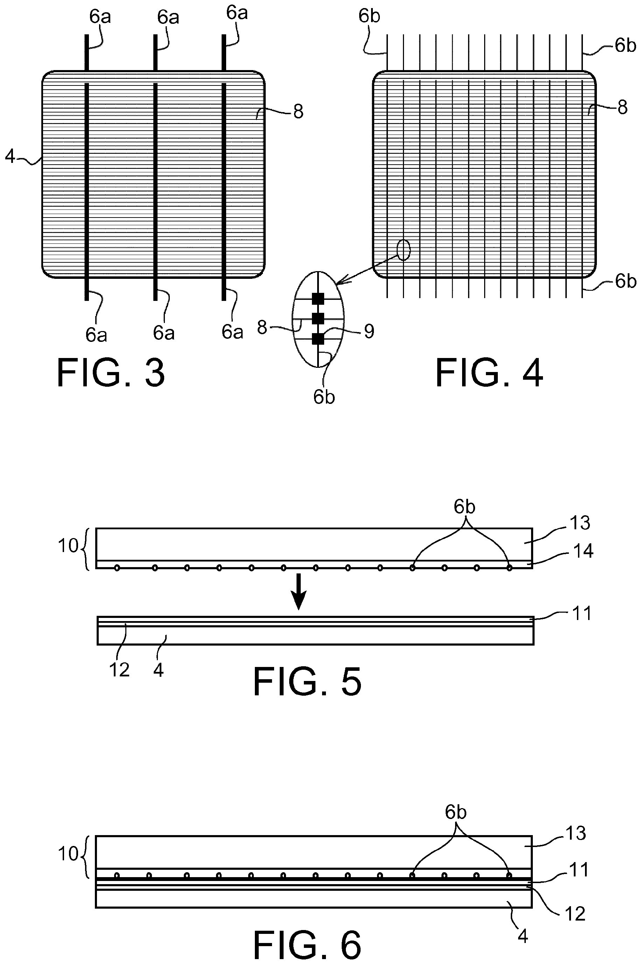

La présente invention est ainsi concernée par l'interconnexion des cellules photovoltaïques. On distingue classiquement deux techniques majeures pour interconnecter les cellules photovoltaïques d'une chaîne : les interconnexions en forme de ruban et les interconnexions en forme de fil métallique. Ces deux techniques sont respectivement représentées par les figures 3 et 4.

Sur la figure 3, les interconnexions entre les cellules 4 sont constituées de rubans 6a en cuivre recouverts d'un alliage fusible, typiquement un alliage d'étain et de plomb ou un alliage d'étain et d'argent. Ces rubans 6a de section rectangulaire sont soudés sur des pistes conductrices appelées « busbars » et formées en même temps que les doigts de collecte 8 par sérigraphie. Les busbars relient électriquement les doigts de collecte 8 et sont orientés perpendiculairement aux doigts de collecte 8.

Une cellule de 156 mm x 156 mm compte généralement trois rubans de 1,5 mm de large ou quatre rubans de 1,2 mm de large, ces rubans ayant une épaisseur de l'ordre de 0,2 mm. Chaque ruban 6a connecte la face avant d'une cellule 4 à la face arrière de la cellule 4 suivante dans la chaîne (non représentée sur la figure 3). La mise en série des cellules photovoltaïques 4 au moyen des rubans 6a s'effectue de façon entièrement automatisée, dans un équipement appelé « stringer ».

Plusieurs équipementiers proposent dorénavant de remplacer les rubans de cuivre par des fils métalliques de plus faible section. Par exemple, la technologie « Multi-Busbar» développée par la société « Schmid » et décrite dans l'article « Multi-busbar solar cells and modules : high efficiencies and low silver consumption », S. Braun et al., Energy Procedia, vol. 38, pp. 334-339, 2013, multiplie le nombre de busbars déposés sur la cellule, passant de trois à quinze busbars, et soude à chaque busbar un fil de 200 µm de diamètre. Cette technologie est schématisée sur la figure 4. Les fils 6b sont constitués de cuivre et recouverts d'une fine couche d'un alliage à base d'étain-plomb ou d'étain-argent dont le point de fusion est situé au-dessus de 170°C. Les busbars ont une forme discontinue. Ils se composent de plots de métallisation 9, d'environ 500 µm x 700 µm, alignés sur les doigts de collecte 8. Les plots de métallisation 9 et les doigts de collecte 8 sont généralement réalisés par sérigraphie d'une pâte d'argent. La soudure des fils 6b sur les plots 9 a lieu immédiatement après avoir posé les fils 6b sur les plots 8, dans le même équipement, en chauffant ces éléments à une température de l'ordre de 200°C. Ainsi, l'alliage recouvrant les fils 6b de cuivre est fondu.

Par ailleurs, la technologie « SmartWire » développée par la société « Meyer Burger », connue de DE 102 39 845 C1 et également décrite dans l'article « Smart Wire Connection Technology», T. Söderström et al., Proceedings of the 28th European Photovoltaics Solar Energy Conference, pp. 495-499, 2013, consiste à déposer une nappe de 18 à 36 fils de 200 µm ou 300 µm de diamètre directement sur les doigts de collecte. Autrement dit, les cellules photovoltaïques sont dépourvues de busbars. Les fils sont tenus par un film support en cellophane, acétate ou fluororésine, par exemple, qui est collé sur chaque face des cellules. Les fils ont une âme en cuivre et un revêtement extérieur formé d'un alliage à faible point de fusion. Cet alliage possède une température de fusion inférieure à 150°C, ce qui permet de réaliser la connexion électrique entre les fils et les doigts de collecte, non pas lors de l'étape d'interconnexion des cellules (par chauffage localisé vers 100°C), mais lors de l'étape de lamination des modules photovoltaïques (qui se fait à plus haute température, généralement vers 150-160°C).

Le document WO 2016/198797 A1 décrit aussi un procédé d'interconnexion de cellules photovoltaïques au moyen d'une nappe formée d'une pluralité de fils électriquement conducteurs, les fils étant rendus solidaires entre eux par des portions d'un film support qui sont agencées alternativement sur le dessus et sur le dessous des fils.

Les figures 5 et 6 permettent d'illustrer le principe de la technologie « SmartWire ». La figure 5 illustre schématiquement, en coupe, l'application du film support 10 sur la sérigraphie 11 de la cellule photovoltaïque 4, et la figure 6 illustre schématiquement, en coupe, l'interconnexion électrique obtenue de la cellule 4 de la figure 5 après application du film support 10.

Ainsi, les fils 6b sont tenus par le film support 10 qui comprend une couche en cellophane, acétate ou fluororésine, par exemple, et une couche adhésive de type acrylique, élastomère (ou caoutchouc), polyvinyle éther, ou encore époxy, sur laquelle sont placés les fils 6b. Comme visible sur la figure 5, ce film support 10 est alors plaqué sur la sérigraphie 11 de la cellule 4, cette sérigraphie 11 comprenant les doigts de collecte 8, pour obtenir la structure de la figure 6. De plus, sur ces figures 5 et 6, on peut également voir qu'une couche anti-reflet 12 est prévue entre la cellule photovoltaïque 4 et la sérigraphie 11. Cette couche anti-reflet 12 est typiquement une couche d'oxyde d'indium-étain (ou encore ITO pour « Indium Tin Oxide » en anglais) ou encore une couche de nitrure de silicium (SiN).

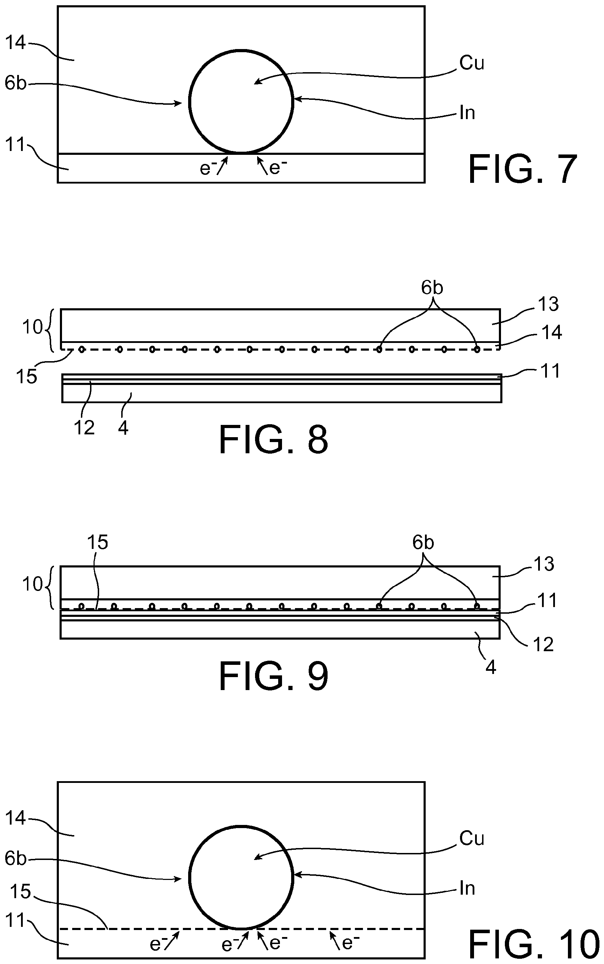

En outre, la figure 7 illustre schématiquement et partiellement, en coupe, le contact électrique obtenu entre un fil 6b et la sérigraphie 11 pour la structure de la figure 6. Plus précisément, le fil 6b comporte une âme en cuivre Cu et un revêtement extérieur formé d'un alliage à faible point de fusion. Au contact avec les doigts de collecte de la sérigraphie 11 a lieu le passage des électrons e⁻.

Les interconnexions en forme de fil métallique permettent de réduire la longueur des doigts de collecte par rapport à la configuration à trois busbars (voir la figure 3), car le nombre de fils est plus important que le nombre de rubans. Cette augmentation du nombre d'interconnexions n'a pas nécessairement d'impact sur l'ombrage de la cellule photovoltaïque en raison de la plus petite taille des fils. Par contre, elle permet de réduire considérablement la quantité d'argent utilisée pour imprimer les doigts de collecte. En effet, les doigts de collecte étant moins longs, on peut soit réduire la largeur des doigts, soit utiliser une pâte moins riche en argent, et donc moins conductrice, pour une résistance série équivalente. En outre, grâce à leur section circulaire, les fils métalliques ont un ombrage effectif sur la cellule photovoltaïque égal à 70 % seulement de leur diamètre, contre 100 % de la largeur des rubans. Ainsi, pour un ensemble d'interconnexions ayant une même section transversales, le taux d'ombrage sur des cellules interconnectées par fils est plus faible que celui sur des cellules interconnectées par rubans.

Les doigts de collecte sont à l'origine de pertes résistives qui détériorent le facteur de forme (ou FF pour « Fill Factor » en anglais) de la cellule photovoltaïque, et donc son rendement. A ces pertes résistives au niveau de la cellule, il faut ajouter les pertes résistives au niveau du module, i.e. dans les interconnexions. Les pertes résistives dans les interconnexions sont proportionnelles au carré du courant électrique généré par le module et à la résistance série des interconnexions, qui dépend notamment de la section de cuivre utilisée.

Une solution pour diminuer ces pertes résistives consisterait donc à augmenter la section des rubans ou des fils de cuivre pour diminuer leur résistance série. Toutefois, cette solution est rarement mise en œuvre en raison de deux inconvénients majeurs. Augmenter la section de cuivre, notamment via son épaisseur, entraînerait une augmentation des contraintes mécaniques dans les interconnexions, dues à la différence des coefficients de dilatation thermique entre le cuivre et le silicium, ce qui nuirait à la fiabilité des modules. De plus, l'augmentation de la section de cuivre via sa largeur aurait un impact négatif sur le taux d'ombrage des cellules photovoltaïques.

Il existe ainsi un besoin pour proposer une solution alternative d'interconnexion visant à améliorer la distribution du courant électrique et donc à réduire les pertes électriques.

### EXPOSÉ DE L'INVENTION

L'invention a pour but de remédier au moins partiellement aux besoins mentionnés précédemment et aux inconvénients relatifs aux réalisations de l'art antérieur.

L'invention a ainsi pour objet, selon l'un de ses aspects, un procédé d'interconnexion de cellules photovoltaïques comportant l'étape de solidarisation, notamment par collage, d'un film support sur les cellules photovoltaïques, le film support comportant un matériau polymère et une pluralité de fils métalliques d'interconnexion des cellules photovoltaïques formant ainsi une électrode,
caractérisé en ce que le film support comporte en outre une pluralité de nanofils métalliques reliés électriquement aux fils métalliques.

Le procédé d'interconnexion selon l'invention permet l'interconnexion d'une pluralité de cellules photovoltaïques disposées les unes à côté des autres par l'application d'un même film support solidarisé, notamment collé, sur toutes les faces des cellules, de façon semblable à la technologie « SmartWire » décrite auparavant.

Par « nanofils métalliques », on désigne des nanostructures métalliques, dont le diamètre est exprimé en nanomètre et dont le facteur de forme longueur/diamètre varie entre 2 et 10 000 et est de préférence supérieur à 100. Il s'agit notamment de fils métalliques avec un diamètre compris entre quelques dizaines à quelques centaines de nanomètres.

De façon avantageuse, l'invention permet donc d'obtenir sur le film support, avant son application sur les cellules photovoltaïques, un réseau de nanofils métalliques et de fils métalliques interconnectés entre eux.

Le procédé d'interconnexion selon l'invention peut en outre comporter l'une ou plusieurs des caractéristiques suivantes prises isolément ou suivant toutes combinaisons techniques possibles.

Les nanofils métalliques peuvent être des nanofils d'un métal noble ou non noble, ou encore d'un alliage de métaux nobles ou non nobles, ou encore d'un alliage d'un ou de métaux nobles avec un ou des métaux non nobles.

En particulier, les nanofils métalliques peuvent être préférentiellement des nanofils d'argent, voire encore d'or, de cuivre et/ou de nickel.

Par « les nanofils métalliques sont des nanofils d'argent (ou un autre métal) », on entend que plus de 80 % des nanofils sont véritablement des nanofils d'argent (ou un autre métal), et de préférence au moins 90 % des nanofils sont véritablement des nanofils d'argent (ou un autre métal). Par exemple, des nanofils dits « d'argent » peuvent comporter 90 % de nanofils véritablement en argent et 10 % de nanofils en un autre métal, par exemple le cuivre.

Les nanofils métalliques peuvent présenter un diamètre compris entre 20 nm et 500 nm, notamment entre 20 nm et 50 nm.

De plus, la masse surfacique des éléments conducteurs électriques de l'électrode, comprenant les nanofils métalliques et les fils métalliques, peut être comprise entre 10 mg/m² et 500 mg/m², notamment entre 10 mg/m² et 200 mg/m², notamment encore entre 20 mg/m² et 50 mg/m².

De façon avantageuse, l'utilisation de nanofils métalliques de faible diamètre, notamment inférieur à 50 nm, ainsi qu'un contrôle de la densité des nanofils, peuvent limiter de façon significative la légère absorption du flux lumineux par les nanofils métalliques.

Par ailleurs, les nanofils métalliques peuvent présenter une longueur comprise entre 1 µm et 500 µm, notamment entre 1 µm et 50 µm.

De préférence, les cellules photovoltaïques peuvent être recouvertes d'une couche anti-reflet, notamment une couche d'oxyde d'indium-étain (ITO) ou encore une couche de nitrure de silicium (SiN), en vis-à-vis du film support.

Le film support peut comporter une couche optiquement transparente isolante électriquement, notamment une couche en cellophane, acétate ou fluororésine, par exemple, et une couche adhésive, notamment de type acrylique, élastomère (ou caoutchouc), polyvinyle éther, ou encore époxy.

En particulier, selon un premier mode de réalisation, le film support peut comporter une couche polymère, notamment une couche en cellophane, acétate ou fluororésine, par exemple, et une couche adhésive, notamment une couche de type acrylique, élastomère (ou caoutchouc), polyvinyle éther, ou encore époxy, la couche adhésive comportant la pluralité de fils métalliques, et le procédé comportant l'étape de dépôt par pulvérisation des nanofils métalliques sur la couche adhésive et les fils métalliques avant l'étape de solidarisation, notamment de collage, du film support sur les cellules photovoltaïques.

Selon un deuxième mode de réalisation, le film support peut comporter une couche polymère, notamment une couche en cellophane, acétate ou fluororésine, par exemple, et une couche adhésive, notamment une couche de type acrylique, élastomère (ou caoutchouc), polyvinyle éther, ou encore époxy, et le procédé comportant l'étape de dépôt par pulvérisation des nanofils métalliques sur la couche adhésive suivie de l'étape de solidarisation, notamment de collage, de la pluralité de fils métalliques sur la couche adhésive déjà munie des nanofils métalliques, avant l'étape de solidarisation, notamment de collage, du film support sur les cellules photovoltaïques.

Selon un troisième mode de réalisation, le film support peut comporter une couche polymère, notamment une couche en cellophane, acétate ou fluororésine, par exemple, et une couche adhésive, notamment une couche de type acrylique, élastomère (ou caoutchouc), polyvinyle éther, ou encore époxy, dans laquelle sont incorporés les nanofils métalliques et sur laquelle la pluralité de fils métalliques est collée.

Selon un quatrième mode de réalisation, le film support peut comporter une couche d'encapsulant dans laquelle sont incorporés les nanofils métalliques et la pluralité de fils métalliques. Cette couche d'encapsulant peut être telle que l'ensemble encapsulant du module photovoltaïque.

Dans tous les modes de réalisation de l'invention, les cellules photovoltaïques peuvent être recouvertes d'une couche de sérigraphie comprenant des doigts de contact pour l'interconnexion avec les fils métalliques. En variante, les cellules photovoltaïques peuvent n'être recouvertes d'aucune couche de sérigraphie.

En outre, l'invention a encore pour objet, selon un autre de ses aspects, un procédé de fabrication d'un module photovoltaïque comportant :
- une première couche transparente formant la face avant du module photovoltaïque, destinée à recevoir un flux lumineux,
- une pluralité de cellules photovoltaïques disposées côte à côte et reliées électriquement entre elles par le procédé d'interconnexion de cellules photovoltaïques tel que défini précédemment,
- un ensemble encapsulant la pluralité de cellules photovoltaïques,
- une deuxième couche formant la face arrière du module photovoltaïque, l'ensemble encapsulant et la pluralité de cellules photovoltaïques étant situés entre les première et deuxième couches.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant », il faut comprendre que la pluralité de cellules photovoltaïques est disposée dans un volume, par exemple hermétiquement clos vis-à-vis des liquides, au moins en partie formé par au moins une couche composée d'un matériau polymère dit d'encapsulation. En général, on utilise au moins deux couches d'encapsulation disposées de part et d'autre des cellules photovoltaïques et réunies entre elles après assemblage, notamment par lamination, pour former l'ensemble encapsulant les cellules. Ainsi, initialement, c'est-à-dire avant toute opération d'assemblage, l'ensemble encapsulant peut être constitué par au moins deux couches de matériau d'encapsulation, dites couches de cœur, entre lesquelles la pluralité de cellules photovoltaïques est encapsulée. Toutefois, pendant l'opération d'assemblage, le ou les matériaux d'encapsulation fondent pour ne former, après l'opération d'assemblage, qu'une seule couche (ou ensemble) solidifiée dans laquelle sont noyées ou encapsulées les cellules photovoltaïques.

L'ensemble encapsulant peut notamment être réalisé à partir d'au moins un matériau polymère choisi parmi : le poly(éthylène-acétate de vinyle) (EVA), les ionomères, les polyoléfines, les acétals de vinyle, tels que les polyvinylbutyrals (PVB), les chlorures de polyvinyle (PVC), les polydiméthylsiloxanes, les polyuréthanes (PU) ou encore le polyméthacrylate de méthyle (PMMA), l'éthylène-acrylate de méthyle (EMA), le butylacrylate d'éthylène (EBA), l'éthylène-propylène (EPM/EPDM).

Par ailleurs, le procédé de fabrication selon l'invention peut comporter l'étape de lamination à chaud, à une température supérieure ou égale à 90°C, notamment supérieure ou égale à 100°C, notamment encore supérieure ou égale à 120°C, et pendant une durée du cycle de lamination d'au moins 10 minutes, des couches constitutives du module photovoltaïque de sorte à finaliser l'interconnexion des fils métalliques et des nanofils métalliques.

La première couche peut être réalisée en verre, ou encore en au moins un matériau polymère, tel que le polyméthacrylate de méthyle (PMMA), le polycarbonate (PC), des fibres de verre ou de carbone imprégnées, entre autres. La deuxième couche peut être réalisée en verre, en métal ou encore en au moins un matériau polymère tel que le polyméthacrylate de méthyle (PMMA), le polycarbonate (PC), des fibres de verre ou de carbone imprégnées, entre autres.

De plus, l'ensemble encapsulant peut préférentiellement être réalisé à partir de deux couches de poly(éthylène-acétate de vinyle) (EVA) entre lesquelles sont disposées les cellules photovoltaïques.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres. Par ailleurs, les cellules photovoltaïques peuvent présenter une épaisseur comprise entre 1 et 300 µm.

Le module photovoltaïque peut en outre comporter une boîte de jonction, destinée à recevoir le câblage nécessaire à l'exploitation du module photovoltaïque.

Par ailleurs, quand bien même la première couche formant la face avant du module photovoltaïque est transparente, la deuxième couche formant la face arrière du module photovoltaïque peut être ou non transparente, étant notamment opaque.

Le procédé d'interconnexion et le procédé de fabrication selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 2 représente, en vue éclatée, le module photovoltaïque de la figure 1,
- les figures 3 et 4 représentent schématiquement deux techniques d'interconnexion de cellules photovoltaïques selon l'art antérieur,
- la figure 5 illustre schématiquement, en coupe, l'application d'une électrode sur la sérigraphie d'une cellule photovoltaïque selon le principe d'interconnexion « SmartWire »,
- la figure 6 illustre schématiquement, en coupe, l'interconnexion électrique obtenue de la cellule photovoltaïque de la figure 5 après application de l'électrode,
- la figure 7 illustre schématiquement et partiellement, en coupe, le contact électrique obtenu entre un fil métallique et la sérigraphie pour la cellule photovoltaïque de la figure 6,
- la figure 8 illustre schématiquement, en coupe, l'application d'une électrode sur une pluralité de cellules photovoltaïques selon un premier mode de réalisation du procédé d'interconnexion selon l'invention,
- la figure 9 illustre schématiquement, en coupe, l'interconnexion électrique obtenue des cellules photovoltaïques de la figure 8 après application de l'électrode,
- la figure 10 illustre schématiquement et partiellement, en coupe, le contact électrique obtenu entre un fil métallique, les nanofils métalliques et la sérigraphie pour les cellules photovoltaïques de la figure 9,
- la figure 11 illustre schématiquement et partiellement, en coupe, selon une vue semblable à celle de la figure 10, un deuxième mode de réalisation du procédé d'interconnexion selon l'invention,
- la figure 12 illustre schématiquement et partiellement, en coupe, l'électrode utilisé pour un troisième mode de réalisation d'un procédé d'interconnexion selon l'invention,
- la figure 13 illustre schématiquement, en coupe, l'application d'une électrode sur une pluralité de cellules photovoltaïques selon un quatrième mode de réalisation du procédé d'interconnexion selon l'invention,
- la figure 14 illustre schématiquement, en coupe, l'interconnexion électrique obtenue des cellules photovoltaïques de la figure 13 après application de l'électrode,
- la figure 15 illustre schématiquement et partiellement, en coupe, le contact électrique obtenu entre un fil métallique et les nanofils d'argent contenus dans la couche d'encapsulant de la figure 13,
- la figure 16 illustre schématiquement, en coupe, l'application d'une électrode, tel que celui du troisième mode de réalisation de l'invention, sur une pluralité de cellules photovoltaïques selon un cinquième mode de réalisation du procédé d'interconnexion selon l'invention,
- la figure 17 illustre schématiquement, en coupe, l'interconnexion électrique obtenue des cellules photovoltaïques de la figure 16 après application de l'électrode, et
- la figure 18 illustre schématiquement et partiellement, en coupe, le contact électrique obtenu entre un fil métallique, la couche adhésive chargée en nanofils d'argent et la couche anti-reflet pour les cellules photovoltaïques de la figure 16.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 à 7 ont déjà été décrites dans la partie relative à l'état de la technique antérieure et au contexte technique de l'invention.

De plus, il est à noter qu'un module photovoltaïque 1 obtenu par le procédé de fabrication conforme à l'invention peut comporter des couches constitutives semblables à celles décrites en référence aux figures 1 et 2, lesquelles ne sont donc pas nécessairement décrites de nouveau.

En outre, dans ce qui suit, on considère que les nanofils métalliques 15 sont des nanofils d'argent. Toutefois, il pourrait en être autrement comme expliqué précédemment.

La figure 8 permet d'illustrer schématiquement, en coupe, l'application d'un film support 10 sur une pluralité de cellules photovoltaïques 4 (seule une cellule est représentée ici) selon un premier mode de réalisation du procédé d'interconnexion selon l'invention. La figure 9 illustre par ailleurs schématiquement, en coupe, l'interconnexion électrique obtenue des cellules photovoltaïques 4 après application du film support 10.

En outre, la figure 10 illustre schématiquement et partiellement, en coupe, le contact électrique obtenu entre un fil métallique 6b, les nanofils d'argent 15 et la sérigraphie 11 pour les cellules photovoltaïques 4. Le passage des électrons e⁻ a lieu également au contact des nanofils d'argent.

Comme visible sur la figure 8, les cellules photovoltaïques 4 sont recouvertes d'une couche anti-reflet 12 qui peut par exemple être une couche d'oxyde d'indium-étain (ITO) ou encore une couche de nitrure de silicium (SiN), sur laquelle les doigts de collecte sont réalisés par sérigraphie 12.

Par ailleurs, le film support 10 forme une électrode composée d'un film colaminé d'une couche polymère 13 en polyéthylène téréphtalate (PET) et d'une couche adhésive 14 de type acrylique, élastomère (ou caoutchouc), polyvinyle éther, ou encore époxy. Les fils métalliques 6b comportent une âme métallique qui peut être en cuivre Cu et un revêtement extérieur formé d'un alliage à faible point de fusion, comme visible sur la figure 10. Les fils métalliques 6b de cuivre étamés, de diamètre compris entre 200 et 300 µm, ont été collés sur la couche adhésive 14.

Alors, une solution de nanofils d'argent peut être purifiée, par exemple comme selon la méthode décrite dans la demande internationale WO 2015/177717 A1 de la Demanderesse. Un retrait des poussières supérieures à 1 µm peut ensuite être effectué à l'aide d'un rouleau antistatique.

Le substrat formé par le colaminé des deux couches polymère 13 et adhésive 14 est alors positionné à plat, et un traitement plasma O₂ est réalisé.

Alors, le procédé comporte l'étape de dépôt par pulvérisation, notamment par spray ultrasonique, de la solution de nanofils d'argent 15 sur la couche adhésive 14. Plus précisément, une vaporisation en fines gouttelettes est réalisée. Les paramètres réglés peuvent être la concentration de la solution, le débit, la vitesse de balayage et la température de la sole.

On obtient ainsi le film support 10 pourvu des fils métalliques 6b et des nanofils d'argent 15, prêt à être collé sur les cellules photovoltaïques 4.

Alors, à partir de ces cellules interconnectées, un module photovoltaïque 1 peut être fabriqué selon un procédé classique comprenant une étape de lamination, par exemple à une température comprise entre 90°C et 120°C, au cours de laquelle l'adhésion et les contacts électriques vont être améliorés entre les fils métalliques 6b et les nanofils d'argent 15. L'interconnexion entre nanofils d'argent 15 et fils métalliques 6b est donc achevée complètement lors de l'étape de lamination.

Avantageusement, pour le module photovoltaïque 1 obtenu, non seulement le courant généré par les cellules photovoltaïques 4 est transporté par le biais de la sérigraphie 11 et des fils métalliques 6b, mais également par le biais des nanofils d'argent 15.

De façon avantageuse, ce premier exemple de réalisation du procédé d'interconnexion selon l'invention permet le dépôt des nanofils d'argent sur l'électrode (film support et fils métalliques) sans nécessiter une étape d'adhésion des fils de cuivre au film support avant la réalisation de l'interconnexion des cellules entre elles.

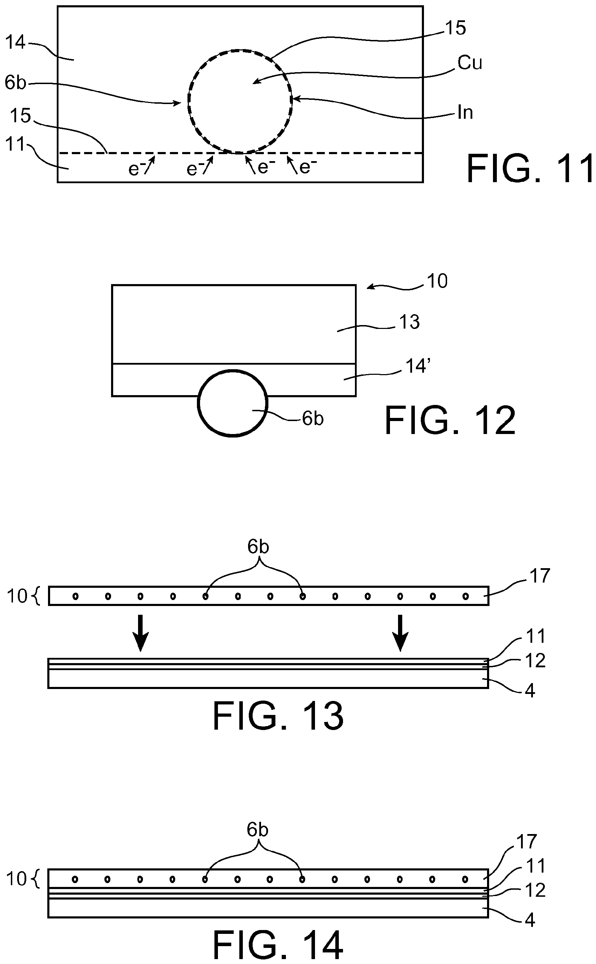

La figure 11 illustre schématiquement et partiellement, en coupe, selon une vue semblable à celle de la figure 10 décrite précédemment, un deuxième mode de réalisation du procédé d'interconnexion selon l'invention.

Ce deuxième mode de réalisation est exactement le même que le premier mode de réalisation hormis le fait que les nanofils d'argent 15 sont déposés sur la couche adhésive 14 avant les fils métalliques 6b.

Plus précisément, le dépôt de nanofils d'argent 15 est réalisé sur la couche adhésive 14 du film support colaminé PET/PO. Puis, cette électrode formée par ce film support 10 est terminée par l'ajout des fils métalliques 6b en cuivre. L'électrode peut alors être collée sur les cellules photovoltaïques 4.

Au niveau de la zone de contact schématisée sur la figure 11, on constate que les nanofils d'argent 15 entourent le fil de cuivre 6b.

De façon avantageuse, ce deuxième mode de réalisation permet de pouvoir déposer les nanofils d'argent 15 sur une surface plane, à savoir la couche adhésive 14, et d'avoir un contact direct entre les fils métalliques 6b et la sérigraphie 11 des cellules photovoltaïques 4, comme pour un procédé standard d'interconnexion multi-fils.

La figure 12 illustre schématiquement et partiellement, en coupe, le film support 10 utilisé pour un troisième mode de réalisation d'un procédé d'interconnexion selon l'invention.

Dans ce troisième mode, on choisit de remplacer la couche adhésive 14 de type acrylique, élastomère (ou caoutchouc), polyvinyle éther, ou encore époxy, par une couche adhésive 14' chargée en nanofils d'argent 15, autrement dit une couche adhésive 14' incorporant les nanofils d'argent 15. Alors, les fils métalliques 6b sont collés à cette couche adhésive 14', et le film support 10 ainsi obtenu peut être appliqué sur les cellules photovoltaïques 4.

Avantageusement, ce troisième mode de réalisation de l'invention permet d'avoir les nanofils d'argent 15 intégrés à la couche adhésive 14. Ainsi, les nanofils d'argent 15 ne peuvent pas être arrachés lors de la mise en œuvre (interconnexion des cellules à l'aide de l'électrode).

La figure 13 permet d'illustrer schématiquement, en coupe, l'application d'un film support 10 sur une pluralité de cellules photovoltaïques 4 selon un quatrième mode de réalisation du procédé d'interconnexion selon l'invention. La figure 14 illustre par ailleurs schématiquement, en coupe, l'interconnexion électrique obtenue des cellules photovoltaïques 4 après application du film support 10.

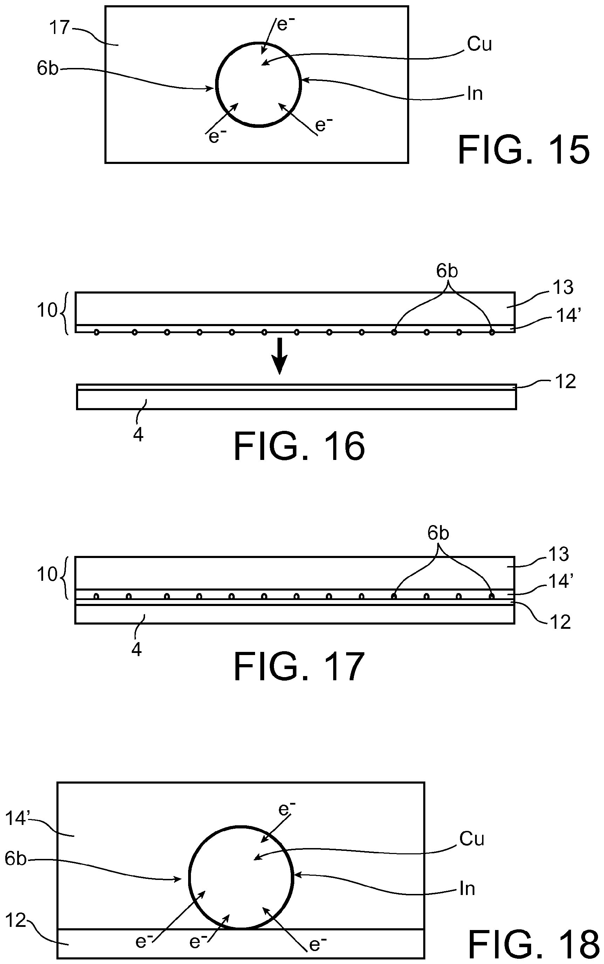

En outre, la figure 15 illustre schématiquement et partiellement, en coupe, le contact électrique obtenu entre un fil métallique 6b et les nanofils d'argent contenus dans la couche d'encapsulant 17.

Dans ce quatrième mode de réalisation, le film support 10 en colaminé PET/PO est remplacé par une couche d'encapsulant 17 chargée en nanofils d'argent. Cette couche d'encapsulant 17 peut être réalisée à partir d'un matériau tels que ceux décrits précédemment pour l'ensemble encapsulant du module photovoltaïque 1.

La concentration massique en nanofils d'argent dans la couche d'encapsulant 17 peut être variable suivant le type d'encapsulant, et par exemple être égale de 1 à 20 % massique, de préférence de 2 à 5 % massique.

Avantageusement, ce quatrième mode de réalisation permet l'utilisation d'un seul matériau d'encapsulation des cellules photovoltaïques 4, évitant les pertes par réflexion aux interfaces. De plus, les nanofils d'argent ne peuvent plus être arrachés en cas de contact avec la surface de l'encapsulant lors de la mise en œuvre.

Dans les quatre modes de réalisation décrits en référence aux figures 8 à 15, les cellules photovoltaïques sont recouvertes d'une couche anti-reflet 12, elle-même recouverte d'une couche de sérigraphie 11 comprenant les doigts de contact pour l'interconnexion avec les fils métalliques 6b. Toutefois, l'ajout de nanofils d'argent 15 permet de réduire, voire de supprimer cette sérigraphie 11.

Ainsi, le cinquième mode de réalisation du procédé d'interconnexion selon l'invention peut prévoir de reproduire les quatre modes décrits précédemment sans utilisation d'une sérigraphie 11.

Plus précisément, la figure 16 permet d'illustrer schématiquement, en coupe, l'application d'un film support 10, tel que celui du troisième mode de réalisation de l'invention, sur une pluralité de cellules photovoltaïques 4 selon un cinquième mode de réalisation du procédé d'interconnexion selon l'invention. La figure 17 illustre par ailleurs schématiquement, en coupe, l'interconnexion électrique obtenue des cellules photovoltaïques 4 après application du film support 10.

En outre, la figure 18 illustre schématiquement et partiellement, en coupe, le contact électrique obtenu entre un fil métallique 6b, la couche adhésive 14' chargée en nanofils d'argent et la couche anti-reflet 12 pour les cellules photovoltaïques 4.

Ainsi, le film support 10 comporte une couche polymère 13 en cellophane, acétate ou fluororésine, par exemple, et une couche adhésive 14' de type acrylique, élastomère (ou caoutchouc), polyvinyle éther, ou encore époxy dans laquelle sont incorporés les nanofils d'argent. De plus, les fils métalliques 6b peuvent être également incorporés dans la couche adhésive 14' ou bien encore être collés sur celle-ci.

De façon avantageuse, cette solution permet d'économiser la pâte de sérigraphie habituellement utilisée grâce à l'ajout des nanofils d'argent.

Bien entendu, l'invention n'est pas limitée aux exemples de réalisation qui viennent d'être décrits. Diverses modifications peuvent y être apportées par l'homme du métier.

## Revendications

1. Procédé d'interconnexion de cellules photovoltaïques (4) comportant l'étape de solidarisation d'un film support (10) sur les cellules photovoltaïques (4), le film support (10) comportant un matériau polymère et une pluralité de fils métalliques (6b) d'interconnexion des cellules photovoltaïques (4) formant ainsi une électrode, **caractérisé en ce que** le film support (10) comporte en outre une pluralité de nanofils métalliques (15) reliés électriquement aux fils métalliques (6b).

2. Procédé selon la revendication 1, **caractérisé en ce que** les nanofils métalliques (15) sont des nanofils d'argent.

3. Procédé selon la revendication 1 ou 2, **caractérisé en ce que** les nanofils métalliques (15) présentent un diamètre compris entre 20 nm et 500 nm, notamment entre 20 nm et 50 nm.

4. Procédé selon l'une des revendications précédentes, **caractérisé en ce que** la masse surfacique des éléments conducteurs électriques du film support (10), comprenant les nanofils métalliques (15) et les fils métalliques (6b), est comprise entre 10 mg/m² et 500 mg/m², notamment entre 10 mg/m² et 200 mg/m², notamment encore entre 20 mg/m² et 50 mg/m².

5. Procédé selon l'une quelconque des revendications précédentes, **caractérisé en ce que** les nanofils métalliques (15) présentent une longueur comprise entre 1 µm et 500 µm, notamment entre 1 µm et 50 µm.

6. Procédé selon l'une quelconque des revendications précédentes, **caractérisé en ce que** les cellules photovoltaïques (4) sont recouvertes d'une couche anti-reflet (12), notamment une couche d'oxyde d'indium-étain (ITO) ou encore une couche de nitrure de silicium (SiN), en vis-à-vis du film support (10).

7. Procédé selon l'une quelconque des revendications précédentes, **caractérisé en ce que** le film support (10) comporte une couche polymère (13), notamment une couche en cellophane, acétate ou fluororésine, et une couche adhésive (15), notamment une couche de type acrylique, élastomère, polyvinyle éther ou époxy, la couche adhésive (14) comportant la pluralité de fils métalliques (6b),
et **en ce que** le procédé comporte l'étape de dépôt par pulvérisation des nanofils métalliques (15) sur la couche adhésive (14) et les fils métalliques avant l'étape de solidarisation, notamment de collage, du film support (10) sur les cellules photovoltaïques (4).

8. Procédé selon l'une quelconque des revendications 1 à 6, **caractérisé en ce que** le film support (10) comporte une couche polymère (13), notamment une couche en cellophane, acétate ou fluororésine, et une couche adhésive (14), notamment une couche de type acrylique, élastomère, polyvinyle éther ou époxy,
**en ce que** le procédé comporte l'étape de dépôt par pulvérisation des nanofils métalliques (15) sur la couche adhésive (15) suivie de l'étape de solidarisation, notamment de collage, de la pluralité de fils métalliques (6b) sur la couche adhésive (14) déjà munie des nanofils métalliques (15), avant l'étape de solidarisation, notamment de collage, du film support (10) sur les cellules photovoltaïques (4).

9. Procédé selon l'une quelconque des revendications 1 à 6, **caractérisé en ce que** le film support (10) comporte une couche polymère (13), notamment une couche en cellophane, acétate ou fluororésine, et une couche adhésive (14'), notamment une couche de type acrylique, élastomère, polyvinyle éther ou époxy, dans laquelle sont incorporés les nanofils métalliques (15) et sur laquelle la pluralité de fils métalliques (6b) est collée.

10. Procédé selon l'une quelconque des revendications 1 à 6, **caractérisé en ce que** le film support (10) comporte une couche d'encapsulant (17) dans laquelle sont incorporés les nanofils métalliques (15) et la pluralité de fils métalliques (6b).

11. Procédé selon l'une quelconque des revendications précédentes, **caractérisé en ce que** les cellules photovoltaïques (4) sont recouvertes d'une couche de sérigraphie (11) comprenant des doigts de contact pour l'interconnexion avec les fils métalliques (6b).

12. Procédé selon l'une quelconque des revendications 1 à 10, **caractérisé en ce que** les cellules photovoltaïques (4) ne sont recouvertes d'aucune couche de sérigraphie (11).

13. Procédé de fabrication d'un module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles par le procédé d'interconnexion de cellules photovoltaïques (4) selon l'une quelconque des revendications précédentes,
- un ensemble encapsulant (3) la pluralité de cellules photovoltaïques (4),
- une deuxième couche (5) formant la face arrière du module photovoltaïque (1), l'ensemble encapsulant (3) et la pluralité de cellules photovoltaïques (4) étant situés entre les première (2) et deuxième (5) couches.

14. Procédé selon la revendication 13, **caractérisé en ce que** l'ensemble encapsulant (3) est réalisé à partir d'au moins un matériau polymère choisi parmi : le poly(éthylène-acétate de vinyle) (EVA), les ionomères, les polyoléfines, les acétals de vinyle, tels que les polyvinylbutyrals (PVB), les chlorures de polyvinyle (PVC), les polydiméthylsiloxanes, les polyuréthanes (PU) ou encore le polyméthacrylate de méthyle (PMMA), l'éthylène-acrylate de méthyle (EMA), le butylacrylate d'éthylène (EBA), l'éthylène-propylène (EPM/EPDM).

15. Procédé selon la revendication 13 ou 14, **caractérisé en ce qu'**il comporte l'étape de lamination à chaud, à une température supérieure ou égale à 90°C, notamment supérieure ou égale à 100°C, notamment encore supérieure ou égale à 120°C, et pendant une durée du cycle de lamination d'au moins 10 minutes, des couches constitutives (2, 3, 4, 5) du module photovoltaïque (1) de sorte à finaliser l'interconnexion des fils métalliques (6b) et des nanofils métalliques (15).

## Patentansprüche

1. Verfahren zum Verbinden von photovoltaischen Zellen (4), umfassend den Schritt des Fixierens einer Trägerfolie (10) an die photovoltaischen Zellen (4), wobei die Trägerfolie (10) ein Polymermaterial und eine Vielzahl von Metalldrähten (6b) zum Verbinden der photovoltaischen Zellen (4) miteinander enthält, wodurch eine Elektrode gebildet wird,
**dadurch gekennzeichnet, dass**
die Trägerfolie (10) ferner eine Vielzahl von metallischen Nanodrähten (15) enthält, die elektrisch mit den Metalldrähten (6b) verbunden sind.

2. Verfahren nach Anspruch 1,
**dadurch gekennzeichnet, dass**
es sich bei den metallischen Nanodrähten (15) um Silber-Nanodrähte handelt.

3. Verfahren nach Anspruch 1 oder 2,
**dadurch gekennzeichnet, dass**
die metallischen Nanodrähte (15) einen Durchmesser zwischen 20 nm und 500 nm, insbesondere zwischen 20 nm und 50 nm, aufweisen.

4. Verfahren nach einem der vorangehenden Ansprüche,
**dadurch gekennzeichnet, dass**
die Flächenmasse der elektrisch leitenden Elemente der Trägerfolie (10) mit den metallischen Nanodrähten (15) und den Metalldrähten (6b) zwischen 10 mg/m² und 500 mg/m², insbesondere zwischen 10 mg/m² und 200 mg/m², insbesondere zwischen 20 mg/m² und 50 mg/m² beträgt.

5. Verfahren nach einem der vorangehenden Ansprüche,
**dadurch gekennzeichnet, dass**
die metallischen Nanodrähte (15) eine Länge zwischen 1 µm und 500 µm, insbesondere zwischen 1 µm und 50 µm, aufweisen.

6. Verfahren nach einem der vorangehenden Ansprüche,
**dadurch gekennzeichnet, dass**
die photovoltaischen Zellen (4) gegenüber der Trägerfolie (10) mit einer Antireflexionsschicht (12), insbesondere mit einer Indium-Zinnoxid-Schicht (ITO) oder einer Siliziumnitrid-Schicht (SiN), bedeckt sind.

7. Verfahren nach einem der vorangehenden Ansprüche,
**dadurch gekennzeichnet, dass**
die Trägerfolie (10) eine Polymerschicht (13), insbesondere eine Schicht aus Cellophan, Acetat oder Fluorharz, und eine Haftschicht (15), insbesondere eine Schicht vom Typ Acryl, Elastomer, Polyvinylether oder Epoxid, enthält, wobei die Haftschicht (14) die Vielzahl von Metalldrähten (6b) enthält,
und dass das Verfahren den Schritt der Sputterabscheidung der metallischen Nanodrähte (15) auf der Haftschicht (14) und den Metalldrähten vor dem Schritt des Fixierens, insbesondere des Verklebens, der Trägerfolie (10) auf den photovoltaischen Zellen (4) umfasst.

8. Verfahren nach einem der Ansprüche 1 bis 6,
**dadurch gekennzeichnet, dass**
die Trägerfolie (10) eine Polymerschicht (13), insbesondere eine Schicht aus Cellophan, Acetat oder Fluorharz, und eine Haftschicht (14), insbesondere eine Schicht vom Typ Acryl, Elastomer, Polyvinylether oder Epoxid, enthält, und dass das Verfahren den Schritt der Sputterabscheidung der metallischen Nanodrähte (15) auf der Haftschicht (14), gefolgt vom Schritt des Fixierens, insbesondere des Verklebens, der Vielzahl von Metalldrähten (6b) auf der bereits mit den metallischen Nanodrähten (15) versehenen Haftschicht (14) vor dem Schritt des Fixierens, insbesondere des Verklebens, der Trägerfolie (10) auf den photovoltaischen Zellen (4) umfasst.

9. Verfahren nach einem der Ansprüche 1 bis 6,
**dadurch gekennzeichnet, dass**
die Trägerfolie (10) eine Polymerschicht (13), insbesondere eine Schicht aus Cellophan, Acetat oder Fluorharz, und eine Haftschicht (14'), insbesondere eine Schicht vom Typ Acryl, Elastomer, Polyvinylether oder Epoxid, enthält, in welche die metallischen Nanodrähte (15) eingebettet sind und auf welcher die Vielzahl von Metalldrähten (6b) aufgeklebt ist.

10. Verfahren nach einem der Ansprüche 1 bis 6,
**dadurch gekennzeichnet, dass**
die Trägerfolie (10) eine Einkapselungsschicht (17) enthält, in die die metallischen Nanodrähte (15) und die Vielzahl der Metalldrähte (6b) eingebettet sind.

11. Verfahren nach einem der vorangehenden Ansprüche,
**dadurch gekennzeichnet, dass**
die photovoltaischen Zellen (4) mit einer Siebdruckschicht (11) bedeckt sind, die Kontaktfinger zur Verbindung mit den Metalldrähten (6b) enthält.

12. Verfahren nach einem der Ansprüche 1 bis 10,
**dadurch gekennzeichnet, dass**
die photovoltaischen Zellen (4) mit keiner Siebdruckschicht (11) bedeckt sind.

13. Verfahren zur Herstellung eines photovoltaischen Moduls (1), enthaltend:
- eine erste transparente Schicht (2), die die Vorderseite des photovoltaischen Moduls (1) bildet und dazu bestimmt ist, einen Lichtstrom zu empfangen,
- eine Vielzahl von photovoltaischen Zellen (4), die nebeneinander angeordnet und elektrisch miteinander verbunden sind mittels des Verfahrens zum Verbinden von photovoltaischen Zellen (4) nach einem der vorangehenden Ansprüche,
- eine Anordnung (3), die die Vielzahl von photovoltaischen Zellen (4) einkapselt,
- eine zweite Schicht (5), die die Rückseite des photovoltaischen Moduls (1) bildet, wobei sich die Einkapselungsanordnung (3) und die Vielzahl von photovoltaischen Zellen (4) zwischen der ersten (2) und der zweiten (5) Schicht befinden.

14. Verfahren nach Anspruch 13,
**dadurch gekennzeichnet, dass**
die Einkapselungsanordnung (3) aus mindestens einem Polymermaterial hergestellt ist, das aus Poly(ethylenvinylacetat) (EVA), lonomeren, Polyolefinen, Vinylacetalen, wie etwa Polyvinylbutyralen (PVB), Polyvinylchloriden (PVC), Polydimethylsiloxanen, Polyurethanen (PU) oder Polymethylmethacrylat (PMMA), Ethylen-Methylacrylat (EMA), Ethylen-Butyacrylat (EBA), Ethylen-Propylen (EPM/EPDM), ausgewählt ist.

15. Verfahren nach Anspruch 13 oder 14,
**dadurch gekennzeichnet, dass**
es den Schritt des Heißlaminierens der einzelnen Schichten (2, 3, 4, 5) des photovoltaischen Moduls (1) bei einer Temperatur höher oder gleich 90°C, insbesondere höher oder gleich 100°C, insbesondere höher oder gleich 120°C, und für eine Laminierungszyklusdauer von mindestens 10 Minuten, umfasst, um die Verbindung der Metalldrähte (6b) und der metallischen Nanodrähte (15) fertigzustellen.

## Claims

1. A process for interconnecting photovoltaic cells (4) comprising the step of attaching a support film (10) to the photovoltaic cells (4), the support film (10) comprising a polymer material and a plurality of metal wires (6b) for interconnecting the photovoltaic cells (4) thus forming an electrode, **characterized in that** the support film (10) further comprises a plurality of metal nanowires (15) electrically connected to the metal wires (6b).

2. The process as claimed in claim 1, **characterized in that** the metal nanowires (15) are silver nanowires.

3. The process as claimed in claim 1 or 2, **characterized in that** the metal nanowires (15) have a diameter between 20 nm and 500 nm, in particular between 20 nm and 50 nm.

4. The process as claimed in one of the preceding claims, **characterized in that** the mass per unit area of the electrically conductive elements of the support film (10), comprising the metal nanowires (15) and the metal wires (6b), is between 10 mg/m² and 500 mg/m², particularly between 10 mg/m² and 200 mg/m², more particularly between 20 mg/m² and 50 mg/m².

5. The process as claimed in any one of the preceding claims, **characterized in that** the metal nanowires (15) have a length of between 1 µm and 500 µm, in particular between 1 µm and 50 µm.

6. The process as claimed in any one of the preceding claims, **characterized in that** the photovoltaic cells (4) are covered with an antireflection layer (12), in particular a layer of indiumtin oxide (ITO) or a layer of silicon nitride (SiN), opposite the support film (10).

7. The process as claimed in any one of the preceding claims, **characterized in that** the support film (10) comprises a polymer layer (13), in particular a layer of cellophane, acetate or fluororesin, and an adhesive layer (15), in particular a layer of acrylic, elastomer, polyvinyl ether or epoxy type, the adhesive layer (14) comprising a plurality of metal wires (6b), and **in that** the process comprises the step of spray deposition of the metal nanowires (15) on the adhesive layer (14) and the metal wires before the step of attaching, in particular of bonding, the support film (10) to the photovoltaic cells (4).

8. The process as claimed in any one of claims 1 to 6, **characterized in that** the support film (10) comprises a polymer layer (13), in particular a layer of cellophane, acetate or fluororesin, and an adhesive layer (14), in particular a layer of acrylic, elastomer, polyvinyl ether or epoxy type,
**in that** the process comprises the step of spray deposition of the metal nanowires (15) on the adhesive layer (15) followed by the step of attaching, in particular of bonding, the plurality of metal wires (6b) to the adhesive layer (14) already provided with the metal nanowires (15), before the step of attaching, in particular of bonding, the support film (10) to the photovoltaic cells (4).

9. The process as claimed in any one of claims 1 to 6, **characterized in that** the support film (10) comprises a polymer layer (13), in particular a layer of cellophane, acetate or fluororesin, and an adhesive layer (14'), in particular a layer of acrylic, elastomer, polyvinyl ether or epoxy type, in which the metal nanowires (15) are incorporated and to which the plurality of metal wires (6b) are bonded.

10. The process as claimed in any one of claims 1 to 6, **characterized in that** the support film (10) comprises an encapsulating layer (17) in which the metal nanowires (15) and the plurality of metal wires (6b) are incorporated.

11. The process as claimed in any one of the preceding claims, **characterized in that** the photovoltaic cells (4) are covered with a screen-printing layer (11) comprising contact fingers for interconnection with the metal wires (6b).

12. The process as claimed in any one of claims 1 to 10, **characterized in that** the photovoltaic cells (4) are not covered with any screen-printing layer (11).

13. A process for manufacturing a photovoltaic module (1) comprising:
- a first transparent layer (2) forming the front face of the photovoltaic module (1), intended to receive a luminous flux,
- a plurality of photovoltaic cells (4) arranged side by side and electrically connected to each other by the process for interconnecting photovoltaic cells (4) as claimed in any one of the foregoing claims,
- an assembly encapsulating (3) the plurality of photovoltaic cells (4),
- a second layer (5) forming the rear face of the photovoltaic module (1), the encapsulating assembly (3) and the plurality of photovoltaic cells (4) being located between the first (2) and second (5) layers.

14. The process as claimed in claim 13, **characterized in that** the encapsulating assembly (3) is made from at least one polymeric material chosen from: poly(ethylene-vinyl acetate) (EVA), ionomers, polyolefins, vinyl acetals, such as polyvinylbutyrals (PVB), polyvinyl chlorides (PVC), polydimethylsiloxanes, polyurethanes (PU) or polymethyl methacrylate (PMMA), ethylene-methyl acrylate (EMA), ethylene butylacrylate (EBA), ethylene-propylene (EPM/EPDM) .

15. The process as claimed in claim 13 or 14, **characterized in that** it comprises the step of hot laminating, at a temperature greater than or equal to 90°C, particularly greater than or equal to 100°C, more particularly greater than or equal to 120°C, and for a duration of the lamination cycle of at least 10 minutes, the constituent layers (2, 3, 4, 5) of the photovoltaic module (1) so as to finalize the interconnection of the metal wires (6b) and the metal nanowires (15).
